# EUROPEAN PATENT SPECIFICATION

(11) **EP 2 008 303 B1**
(45) Date of publication and mention of the grant of the patent: **16.06.2010**
(21) Application number: 07735369.6
(22) Date of filing: 03.04.2007
(51) Int. Cl.: H01L 23/00, H01L 23/498, H01L 23/538, H01L 25/065

(54) **ELASTICALLY DEFORMABLE INTEGRATED-CIRCUIT DEVICE**
ELASTISCH VERFORMBARE INTEGRIERTE SCHALTUNG
DISPOSITIF DE CIRCUIT INTEGRE A DEFORMATION ELASTIQUE

(30) Priority: 07.04.2006 EP 06112384
(43) Date of publication of application: 31.12.2008
(73) Proprietor: Koninklijke Philips Electronics N.V., 5621 BA Eindhoven (NL)
(72) Inventor: DEKKER, Ronald, NL-5656 AA Eindhoven (NL); MIICHIELSEN, Theodorus, M., NL-5656 AA Eindhoven (NL); ZOUMPOULIDIS, Theodorus, NL-5656 AA Eindhoven (NL)
(74) Representative: Van Velzen, Maaike Mathilde
(86) International application number: PCT/IB2007/051190
(87) International publication number: WO 2007/116344

(56) References cited:
- WO-A-03/021679
- WO-A-2006/006987
- JP-A- 6 036 620
- US-A- 3 519 890
- US-A- 4 754 544
- US-A1- 2004 192 082
- US-A1- 2005 258 519
- US-A1- 2006 071 349
- US-B1- 6 319 019
- US-B1- 6 455 931
- US-B1- 6 479 890
- US-B2- 6 743 982

## Description

The present invention relates to an integrated-circuit device comprising a multitude of separate rigid substrate islands with circuit elements, a respective substrate island being connected to respective neighbor substrate islands by respective elastically deformable connections, which contain at least one respective signaling layer that is made of an electrically conductive material.

Such flexible integrated-circuit devices, herein also referred to as flexible circuits or integrated-circuit devices of the flexible-circuit type, are known from US 6,479,890 B1 and US 6,617671 B1. In such flexible circuits, the rigid substrate islands, which comprise circuit elements, and the elastically deformable connections between them, which provide a signaling layer for signal exchange between substrate islands, form a flexible network or web. Flexible circuits can tolerate bending movements as well as tensile and compressive stresses resulting from such movements while maintaining circuit integrity. In contrast, single-crystal silicon is hard and brittle, and tends to yield to mechanical stress by fracturing, which reduces fabrication yield and product lifetime of integrated-circuit devices.

Flexible circuits offer further specific advantages. For instance, they can have extensions that are scalable from a millimeter scale to a meter scale. Large-area devices can thus be designed in a very cost-effective manner.

It is well known, however, that the signaling layers in the elastically deformable connections, which are for instance made of titanium (Ti), titanium nitride (TiN) or copper (Cu), may contain high levels of mechanical stress. This stress is for instance generated during thermal cycling in the fabrication process and caused by a mismatch in the coefficients of thermal expansion (CTE) between the signaling layer and an adjacent insulator. It can even be the dominating stress contribution in the connections, larger than a stress contribution generated for application purposes by a desired extension, compression or bending of the device.

Inhomogeneous stress is increased in the integrated-circuit device disclosed in US 6,479,890 B1 (Trieu et al.), where some neighboring substrate-island pairs are connected by a flexible foil, which contains one signaling layer, whereas others contain two or more signaling layers in parallel arrangement. Undesired inhomogeneous strain distributions in the flexible web that forms the integrated-circuit device may result, leading to a cracking of connections in the worst case. This can be detrimental for device performance. For example, in sensor applications a regularly spaced arrangement of the substrate islands containing the sensors may be desired, and malpositioning of individual substrate islands or malfunctioning of only some of the connections reduces device reliability.

On the other hand, a flexible connection that contains equal numbers of signaling layers between neighboring substrate islands, as shown in US 6,617671 B1, restricts the freedom of circuit design and limits the applicability of flexible circuits to cases with identical wiring between the substrate islands.

US 6,455,931 discloses a plurality of structurally flexible electrically conductive interconnects, which extends between the readout integrated circuit elements of adjacent substrate islands.

US 6,743,982 refers to a configuration of a sensor array provided with stretchable interconnects for electrically connecting a number of electronic devices that are supported for movement relative to one another by a flexible and/or stretchable substrate.

US 2005/258519 discloses a semiconductor device comprising a number of non-elastically deformable dummy leads and dummy bumps, connected to each other, in order to balance thermal stresses.

It is therefore an object of the present invention to provide an integrated-circuit device of the flexible-circuit type that has reduced inhomogeneous strain contributions and allows complex patterns of electrical connections between the substrate islands.

According to a first aspect of the present invention an integrated-circuit device comprises a multitude of separate rigid substrate islands with circuit elements. A respective substrate island is connected to respective neighbor substrate islands by respective elastically deformable connections. The elastically deformable connections contain at least one respective signaling layer that is made of an electrically conductive material. In the integrated-circuit device of the invention, at least one elastically deformable connection between substrate islands has a signaling layer, which is not electrically connected and thus forms a dummy signaling layer. Furthermore, the elastically deformable connections, which connect a respective substrate island to respective neighbor substrate islands along a first direction, have an elastic deformability in the first direction governed by respective moduli of elasticity, the ratio of which is between 0.5 and 2.0.

The integrated-circuit device of the present invention has elastically deformable connections, which have an elastic deformability in the first direction governed by respective moduli of elasticity, the ratio of which is between 0.5 and 2.0. That means, moduli of elasticity of any pair of the elastically deformable connections in the first direction have a ratio between ½ and 2/1. Moduli of elasticity having a ratio within this interval will also be referred to as balanced moduli of elasticity. This restriction of the modulus of elasticity ratios is connected with the concept of providing at least one dummy signaling layer. For the provision of at least one dummy signaling layer in synergy with the mentioned modulus of elasticity ratio in the above-mentioned limits balances the elastically deformable connections irrespective of the particular requirements of electrical connectivity between the circuit elements of the substrate islands. Dummy signaling layers can be used to balance the modulus of elasticity ratio, where no electrical connection is needed. Use of the invention can me made in choosing an appropriate number of dummy signaling layers for balancing the elastic deformability of different elastically deformable connections in a situation where the required electrical connections of a specific circuit design alone would provide such balanced elastic deformability.

The integrated-circuit device of the invention also has the advantage to allow providing a standard design of balanced elastically deformable connections for many kinds of flexible circuits, irrespective of their individual functionality and circuit requirements. All connections may contain equal numbers of signaling layers, and it is only a matter of the individual design of a particular application of a flexible circuit to either connect an individual signaling layer or not. Such electrical connections of the signaling layers can be either manufactured or omitted without significantly affecting the modulus of elasticity of an elastically deformable connection. Dummy signaling layers can be terminated by small sections of an electrically insulating material.

The modulus of elasticity is also known as Young's modulus. Both terms will be used herein in parallel with the same meaning. The modulus of elasticity, or Young's modulus, is defined as the limit for small strains of the rate of change of stress with strain. For many materials, Young's modulus is a constant over a range of strains so that they obey Hooke's law. However, in non-linear materials, Young's modulus changes with varying strain. For the purpose of the present invention, it is sufficient to ensure that Young's moduli of the elastically deformable connections are balanced over an interval that is relevant for application purposes. Ratios of Young's modulus need not be considered for strain situations, which are not relevant in fabrication or operation of the device.

The modulus of elasticity, or Young's modulus, is a tensor. Elastically deformable connections may be anisotropic, that is, have different values of Young's modulus and therefore exhibit different mechanical properties for stresses applied in different directions. For the purpose of the present invention, it is sufficient to ensure that Young's modulus of the elastically deformable connections is balanced for those directions that are relevant for application purposes. In others, the elastically deformable connections may have different values of Young's modulus.

Since the moduli of elasticity of the bridges govern the strain distribution in the flexible circuit in response to mechanical stress, elastically deformable connections with identical moduli of elasticity yield to identical stress in an identical manner, thus reducing the inhomogeneity of strain in the network that is formed by the flexible circuit. This way, the functional reliability of the integrated-circuit device of the invention is increased over prior-art devices.

Slight deviations of the value of the modulus of elasticity between different elastically deformable connections of the integrated-circuit device may be unavoidable due to fabrication tolerances. A perfectly identical value of the modulus of elasticity for all bridges of an integrated-circuit device thus forms the ideal case according to the invention. Deviations from this ideal case in the range between 0.5 and 2.0, however, are within the scope of the present invention. In preferred embodiments, the ratio of the moduli of elasticity is between 0.67 and 1.5, or even 0.8 and 1.25. Within the present application, to keep the description free from unnecessary repetitions, all embodiments within the range of 0.5 and 2.0 are addressed in common with the term "balanced moduli of elasticity", unless explicitly stated otherwise, when speaking of "identical" values of the modulus of elasticity.

The term "signaling layer" is used herein to denote a layer, which is made of an electrically conductive material, irrespective of whether it is actually used for purposes of signaling between circuit elements of different substrate islands.

The term "elastically deformable connection" shall be construed as any elastically deformable structure that provides a mechanical connection between two substrate islands.

"Deformability" of the elastically deformable connections relates to any type of mechanical deformation. A deformation is a change in shape of an elastically deformable connection with respect to a shape in a stress-free state as a consequence of an application of force. Forces may, without limitation, be tensile (pulling), compressive (pushing), shear, bending or twisting (torsion). For the case of shear, the applicable modulus of elasticity is the shear modulus.

"Elastic" deformability is the ability of a reversible deformation. When application of forces stops, an elastically deformable connection returns to its original shape.

Note that the invention does not exclude a plastic deformation of the bridges, which is a non-reversible deformation. Plastic and elastic deformability typically coexist and apply in different stress regions. A plastic deformability of the bridges may form a useful contribution to the mechanical properties of the bridges in preferred embodiments wherein the elastically deformable connections are inelastically deformable when subjected to a stress that exceeds a threshold stress amount. This allows bringing individual islands at a larger distance from each other after manufacture, i.e. to make the device stretchable. Preferably, the material and/ or structure of the elastically deformable connections are chosen so as to exhibit a remaining elastic deformability upon application of a stress below the threshold stress amount after an inelastical deformation.

The present invention provides a new design rule for the elastically deformable connections between the substrate islands of an integrated-circuit device of the flexible-circuit type. The first design priority is a balanced modulus of elasticity for the elastically deformable connections between the substrate islands of the integrated-circuit device of the invention. This new design rule replaces the previous notation that prioritized the provision of required electrical interconnects between circuit elements of substrate islands. However, following that design rule of the prior art will not lead to an identical value of Young's modulus because different elastically deformable connections typically contain different numbers of interconnects, that is, a different number of electrically connected signaling layers, according to the specific wiring requirements between the circuits provided on two respective substrate islands connected by a bridge. This, in consequence, obviously affects the value of Young' modulus of an individual bridge. The dominance of this prior-art design rule is for instance clearly visible in the integrated-circuit device disclosed in US 6,479,890 B1 (Trieu et al.), where some neighboring substrate-island pairs are connected by a bridge in the form of a flexible foil, which contains one signaling layer, whereas others contain two or more signaling layers in parallel arrangement.

The invention provides a basis to the fabrication of deformable, in particular stretchable integrated circuits with a high degree of deformation symmetry.

In the following, further preferred embodiments of the flexible integrated circuit-device of the invention will be described. Unless stated otherwise explicitly, the embodiments can be combined with each other.

Preferably, the balancing is extended to more than one direction. In a preferred embodiment, therefore, the elastically deformable connections, which connect a respective substrate island to respective different neighbor substrate islands along at least one second direction, which is different from the first direction, have an elastic deformability in the at least one second direction governed by respective moduli of elasticity, the ratio of which is between 0.5 and 2.0. Preferably, the ratio is between 0.67 and 1.5, and more preferably, between 0.8 and 1.25, including the ideal case of a ratio 0f 1.0.

The substrate islands should preferably be much smaller than a radius of curvature that the integrated-circuit device is designed for to avoid cracking of the substrate islands. This way, during bending of the integrated-circuit device within the preset limits, all stress is relieved by the bridges.

Preferably, all substrate islands have identical geometrical extensions. Individual substrate islands preferably have a symmetrical outline, as provided for instance by a square or a circular shape. A preferred embodiment has substrate islands with hexagonal shape. This allows the distance between neighboring substrate islands to be held equal in substantially all directions.

In a further preferred embodiment, the elastically deformable connections of a respective substrate island to its neighbor substrate islands along the first or second direction, or along the first and second directions, comprise an equal number of elastically deformable bridges.

In one embodiment, the elastically deformable bridges form the elastically deformable connections. In another embodiment, the elastically deformable bridges form a part of the elastically deformable connections, in addition, for instance, to an elastically deformable material layer, which supports the bridges. In one such embodiment, the elastically deformable bridges are embedded in an elastically deformable material. The elastically deformable material layer can in addition be used to support the substrate islands.

The elastically deformable material preferably has a coefficient of thermal expansion, which is close enough to that of the elastically deformable bridges so as to prevent a disintegration of the bridges and the elastically deformable material upon an increase of temperature during manufacture or operation of the device.

According to a preferred embodiment of the integrated-circuit device of the invention, the bridges, or the electrically deformable connections in general, comprise equal numbers of signaling layers. The individual signaling layers form either interconnect elements, which electrically connect circuit elements of neighboring substrate islands, or dummy signaling layers. While this embodiment encompasses the case of one signaling layer per bridge, other preferred and advantageous embodiments have bridges with a plurality of signaling layers per bridge, wherein each bridge has an equal number of signaling layers. This embodiment provides an effective way to ensure that the moduli of elasticity of the bridges are balanced. This embodiment also forms an illustrative example of the mentioned design rule of the invention. The bridges contain an equal number of signaling layers even if in some bridges not all signaling layers are actually required for forming interconnects between circuit elements of the neighboring substrate islands. However, the unused signaling layers of such bridges provide a contribution to the respective value of the modulus of elasticity.

The embodiment described in the last paragraph also provides a standard bridge configuration. The use of one standard bridge configuration with respect to the number of signaling layers has further advantages from a reliability point of view. Only one standard configuration needs to be characterized with respect to reliability and monitored during processing. This fits well into the principles of processing efficiency for integrated-circuit devices in the semiconductor industry. For instance, only one standard contact configuration is used in the semiconductor industry between interconnect layers of interconnect structures in integrated-circuit devices.

This embodiment can further be improved, if the signaling layers comprised by different bridges have equal geometrical extensions. If a particularly low interconnect resistance is required or a high current density must be transported between two circuit elements of different substrate islands, two or more signaling layers of one bridge can be used in parallel, instead of providing individual signaling layers with larger geometrical extensions.

Preferably, the signaling layers comprised by different bridges, or elastically deformable connections in general, are made from the same material. This ensures that a common design will lead to values of the modulus of elasticity, which are balanced. Of course, if different materials have identical or nearly identical mechanical properties with respect to the context of the present invention, it will be possible to achieve identical values of the modulus of elasticity of the bridges (connections) even if using such different materials.

A most effective way to achieve identical values for the moduli of elasticity of the bridges is to use a single bridge structure for all bridges, that is, use a single layer structure with a predetermined sequence of metal and other functional layers (like dielectric and barrier layers), and predetermined geometrical extensions as well as material compositions for all layers.

In a further preferred embodiment, two respective neighboring substrate islands are connected with each other by a multitude of elastically deformable bridges. This embodiment also allows realizing a lower series resistance for power supply lines or inductors. In this embodiment, thus, a bridge in the sense of the present invention is formed by a group with a predetermined number of "sub-bridges" between two respective neighboring substrate islands. It is the modulus of elasticity of the individual group of sub-bridges that is to be kept identical according to the present invention. This can easily be achieved when using identical sub-bridges as described in the context of previous preferred embodiments.

The invention is applicable to different types of bridges between the substrate islands. In one embodiment, the bridges take the form of a spiral in a stress-free state. The spiral is configured to partially or completely unwind upon an application of a tensile stress between respective neighboring substrate islands, which are connected by the bridge. Such bridges allow a cost-effective and dens array of substrate islands.

Preferably, the spiral has two spiral arms, which are connected to an individual substrate island with their respective inner end. The respective outer end of a spiral arm is connected to an outer end of a spiral arm that is associated with a neighboring substrate island. Here, the terms "inner end" and "outer end" are only used for purposes of clearness of description, whereas in fact the spiral arms associated with neighboring substrate islands are typically fabricated without "ends". Spiral arms of associated with neighboring substrate islands preferably give way to each other in outer spiral regions without allowing a clear definition of outer ends of the spiral arms.

In an alternative implementation, the bridges take the form of one or more folded beams in a stress-free state. The folded beams are configured to partially or completely unfold upon an application of a tensile stress between respective neighboring substrate islands connected by the bridge. Preferably the beams, without application of tensile stress, are folded in a spring shaped zig-zag fashion.

The substrate islands and the bridges of this embodiment can be supported by an elastically deformable polymer material. In this context, the modulus of elasticity, which is relevant in the context of the present invention, results from the composite structure of the beams and the polymer material.

According to a second aspect of the invention, a method for fabricating a integrated-circuit device that has a multitude of separate rigid substrate islands with circuit elements, the substrate islands being connected to respective neighbor substrate islands by elastically deformable bridges, comprises the steps of
- fabricating a wafer having, at a distance to each other, a multitude of rigid substrate island regions, which contain circuit elements;
- fabricating bridges between neighboring substrate island regions on the wafer and configuring the bridges to provide a mechanical connection bridging the distance between the neighboring substrate island regions;
- processing the wafer to transform the substrate island regions of the wafer into substate islands;
wherein the step of fabricating elastically deformable bridges comprises a step of configuring the bridges to have an either identical or nearly identical value of the modulus of elasticity.

Advantages and embodiments of the method of the second aspect of the invention correspond to those explained herein for the device of the first aspect of the invention. Note that the steps of the method can be performed with time overlap, for instance by using a common lithography step for forming structural features of the substrate islands and of the bridges from a wafer.

In the following, additional embodiments of the method of the second aspect of the invention will be described.

In one embodiment, the step of fabricating a wafer comprises fabricating the circuit elements and the bridges on a first wafer side. The step of processing the wafer comprises:
- depositing an elastic insulating material on the first wafer side;
- attaching the wafer to a support, with the first wafer side facing the support;
- removing wafer material between substrate island regions to form individual substrate islands; and
- removing the support.

The process of the present embodiment improves known substrate transfer technology (STT) methods for forming flexible circuits by integrating the removing step for a formation of separate substrate islands.

In another embodiment, the step of fabricating bridges between neighboring substrate island regions on the wafer comprises fabricating stretchable electrical interconnects between the substrate islands, either before or after the step of processing the wafer. As explained above, the bridges are thus configured to provide both a mechanical and electrical connection between substrate islands during operation of the integrated-circuit device.

In one embodiment, the step of fabricating bridges comprises a step of embedding the electrical interconnects into elastic insulating material. This increases the mechanical protection and support of the electrical interconnects and helps increasing the lifetime of the integrated-circuit device even under substantial or often-changing mechanical stress.

The invention will be elucidated further in the following with reference to the enclosed Figures.
Fig. 1 shows a section of an integrated-circuit device of the flexible-circuit type according to the prior art in a schematic view.
Fig. 2 shows a section of an integrated-circuit device according to an embodiment of the invention.
Fig. 3 shows a schematic side view of an embodiment of the integrated-circuit device of the invention.
Figs. 4 to 8 show different stages during the production of an embodiment of an integrated-circuit device of the invention.
Figs. 9 and 10 show two stages in the fabrication process of an integrated-circuit device of the invention according to another embodiment.
Figs. 11 to 13 show different stages during the production of an another embodiment of an integrated circuit device of the invention.

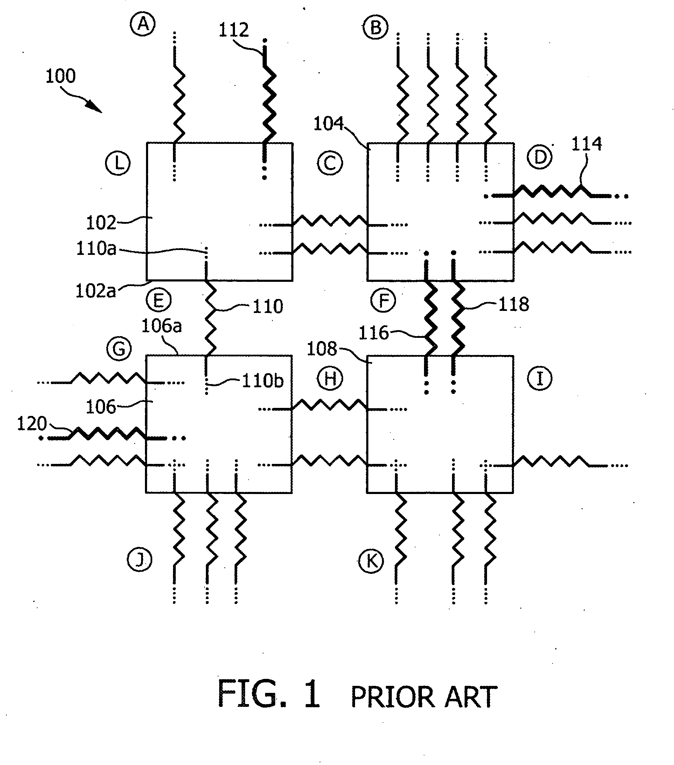

Fig. 1 shows a schematic view of an integrated-circuit device 100 of the flexible-circuit type according to the prior art. The degree of detail shown in Fig. 1 is strongly reduced in order to focus on features of the device, which are relevant in the context of the present invention.

The integrated-circuit device 100 contains substrate islands, four of which are shown by reference numerals 102, 104, 106, and 108. The substrate islands contain circuit blocks (not shown). The circuit blocks on the substrate island can for instance be fabricated by a known CMOS or BiCMOS processing technology on a silicon wafer before separating the silicon wafer into separate substrate islands.

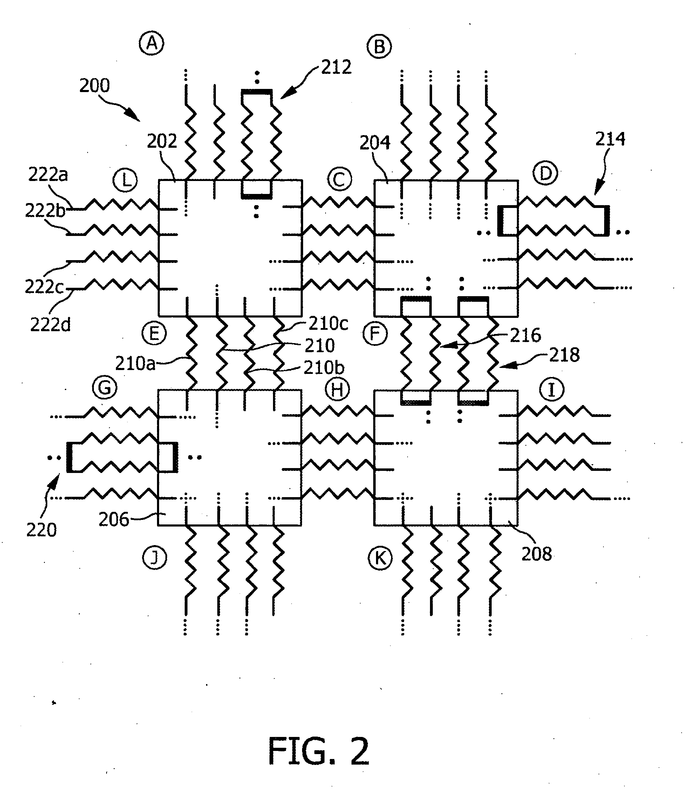

The substrate islands have identical geometrical extensions and are connected by elastically deformable bridges, which are marked by capital letters A to K in Fig. 1. Use of a capital letter L at a position with no bridge will become clear from a below comparison with an integrated-circuit device 200 according to the invention, cf. Fig. 2. Signaling layers that are contained in the respective bridges are made from an electrically conductive material and schematically indicated by zig-zag lines in Fig. 1. The arrangement of the signaling layers serves to indicate a position of circuit blocks on a respective substrate island, to which a respective signaling layer connects. For instance, a signaling layer 110 that connects substrate islands 102 and 106 is positioned slightly left of the center of respective sides 102a and 106a of substrate islands 102 and 106, respectively.

A sequence of dots, shown by way of example with reference numerals 110a and 110b, symbolizes an electrical connection to respective circuit blocks on the substrate islands 102 and 106.

Signaling layers 112 to 120 have a smaller series resistance then other bridges, such as bridge 110, which is indicated by bold printing of the respective symbols used for signaling layers 112 to 120 in Fig. 1. Thus, the prior art device 100 of Fig. 1 uses at least two different types of signaling layers.

The different bridges A to K with different numbers and kinds of signaling layers are shown in Fig. 1 for illustrative purposes. It is clear for the person skilled in the art that in the present Figure, as well as in Fig. 2 below, illustrative examples of a bridge design rule according the prior art (Fig. 1) and according to the invention (Fig. 2) are given, rather than real device structures. The different illustrative bridge configurations provide identical electrical functionality and are marked with capital letters A to L in both figures for making a comparison of the different bridge design easier.

The signaling layers in the bridges of integrated-circuit device 100, which are for instance made of titanium (Ti), titanium nitride (TiN) or copper (Cu), typically contain high levels of mechanical stress. This stress is generated during thermal cycling in the fabrication process and caused by a mismatch in the coefficients of thermal expansion (CTE) between the signaling layer and an adjacent insulator. Undesired inhomogeneous strain distributions in the flexible web that forms the integrated-circuit device 100 may result, leading to a cracking of bridges A to K in the worst case.

Fig. 2 shows a schematic view of an integrated-circuit device 200 according to an embodiment of the invention. The section shown corresponds to that shown for the integrated-circuit device 100 according to the prior art in Fig. 1 to allow a comparison of design rule, which is implemented by integrated-circuit device 200 according to the present invention. Reference numerals in Fig. 2 correspond to those of Fig. 1 for corresponding parts, with the exception of the first digit, which is "2" instead of "1". As mentioned before, the different bridge configurations are again marked by capital letters A to L in Fig. 2 to enable a comparison.

In contrast to the integrated-circuit device 100 according to the prior art, all bridges A to L contain an equal number of signal layers, namely four signal layers. A signal layer is again symbolized by a single zig-zag line. However, a further differentiation is made in Fig. 2 by introducing dummy signaling layers, which are indicated by zig-zag lines without a dotted continuation. For instance bridge E not only contains a connected signaling layer 210 that corresponds to signaling layer 110 of Fig. 1. Bridge E also contains three dummy signaling layers 210a, 210b and 210c.

All bridge configurations of the integrated-circuit device 200 are shown to have four signaling layers, electrically connected or in the form of dummy signaling layers. However, this number of signaling layers is only chosen for illustrative purposes. It is generally desirable to provide a bridge with a maximum possible number of signaling layers in order to provide maximum flexibility for electrically connecting circuit blocks of the individual substrate islands with each other.

The bridges A to L of integrated circuit device 200 have an identical structural setup, also with regard to geometrical layer extension, and material of the different functional layers. This way, it is possible to achieve that all bridges exhibit an identical value of the modulus of elasticity, despite their differences in electrical functionality. This way, an undesired inhomogeneous strain distribution over the web of the integrated-circuit device 200 due to internal stress in the bridges is avoided.

In the design of the bridges, therefore, mechanical properties, and in particular providing an identical value of the modulus of elasticity is the prioritized design constraint.

Under this design constraint, connections with a low series resistance can be realized by connecting two or more signaling layers of a bridge in parallel. This is indicated for pairs of signaling layers 212 to 220, which comprise two signaling layers connected pair wise in parallel by respective metal segments on the substrate islands. This way, the structure of the bridge need not be changed in order to provide a particularly low series resistance between different circuit blocks on neighboring substrate islands.

It is also instructive to also compare the bridge configuration L in the prior art device 100 and in the integrated-circuit device 200 according to the invention. Whereas in the prior art device no electrical connections are required, and therefore no bridge is provided, the integrated-circuit device 200 of Fig. 2 does provide a standard bridge comprising four dummy signaling layers 222a to 222d. This way, an asymmetry in the elastically deformable connections of different substrate islands is avoided. Again, desired mechanical properties rule the design of the bridges, rather than required electrical functionality.

In the following table, the illustrative bridge configurations A to L of the prior art device 100 ("prior art") and of the integrated-circuit device 200 ("invention") are compared in the following categories: the number of signaling layers (applies to both, the prior art device and the device of the invention), the number of low-series resistance layers (used only in the prior art device), the number of dummy signaling layers (used only in the device of the invention) and the number of (parallel-)connected signaling layers (used only in the device of the invention).

**Table 1: Comparison of bridge configurations of Figs. 1 and 2**

| Configuration | Signaling layers | | Low-series-resistance layers | | Dummy signaling layers | | Connected signaling layers | |
|---|---|---|---|---|---|---|---|---|
| | Prior art | Invention | Prior art | Invention | Prior art | Invention | Prior art | Invention |
| A | 2 | 4 | 1 | 0 | 0 | 1 | 0 | 2 |
| B | 4 | 4 | 0 | 0 | 0 | 0 | 0 | 0 |
| C | 2 | 4 | 0 | 0 | 0 | 2 | 0 | 0 |
| D | 3 | 4 | 1 | 0 | 0 | 0 | 0 | 2 |
| E | 1 | 4 | 0 | 0 | 0 | 3 | 0 | 0 |
| F | 2 | 4 | 2 | 0 | 0 | 0 | 0 | 4 |
| G | 3 | 4 | 1 | 0 | 0 | 0 | 0 | 2 |
| H | 2 | 4 | 0 | 0 | 0 | 2 | 0 | 0 |
| I | 1 | 4 | 0 | 0 | 0 | 3 | 0 | 0 |
| J | 3 | 4 | 0 | 0 | 0 | 1 | 0 | 0 |
| K | 3 | 4 | 0 | 0 | 0 | 1 | 0 | 0 |
| L | 0 | 4 | 0 | 0 | 0 | 4 | 0 | 0 |

The foregoing table illustrates that the bridge design of the-prior-art device 100 is ruled by the requirements of electrical connectivity between the substrate islands. An equal electrical functionality, however, can be achieved when following the design rule of the present invention according to which a bridge is provided to each neighboring substrate island, with an equal number of signaling layers with equal geometrical extensions and material choice. This design achieves an identical modulus of elasticity for each of the bridges A to L, while providing an identical electrical functionality as the bridge configurations A to L in the device of Fig. 1.

Where no electrical connection is required between substrate islands, a bridge containing only dummy signaling layers is used. Where less than the maximum number of signaling layers is used in a bridge, the unused signaling layers are fabricated as dummy signaling layers by suitable electrical insulation. Where a signaling layer with a particularly low series resistance is desired, two or more signaling layers are connected in parallel.

The bridges are preferably arranged symmetrically at equal positions on each substrate island. This way, an inhomogeneous strain distribution in the integrated-circuit device 200, that forms a network of interconnected substrate islands (such as 202 to 208) can be avoided.

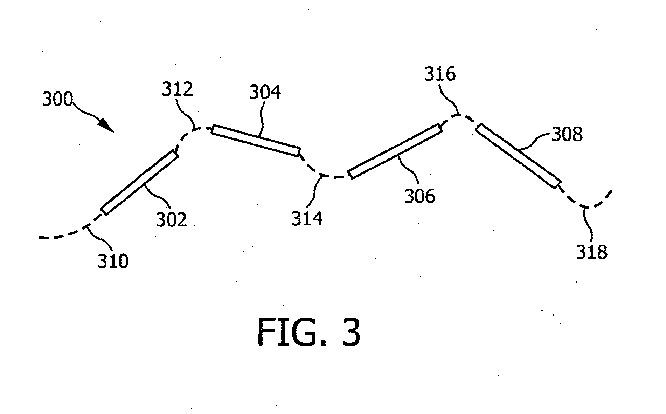

Fig. 3 shows a schematic side view of an embodiment of the integrated-circuit device of the invention. The integrated circuit device 300 shown in Fig. 3 comprises substrate islands, four of which are shown at reference numerals 302 to 308. The substrate islands 302 to 308 are shown a linear arrangement. However, it is understood Fig. 3 as well represents a two-dimensional arrangement of substrate islands.

The substrate islands 302 to 308 are connected with their respective neighbor substrate islands by elastically deformable bridges 310 to 318. The bridges 310 to 318 are indicated by dashed lines. In the bridges 310 to 318 are shown in a bent state to indicate their deformability. The bridges are elastically deformable and, according to the invention, all have an identical or nearly identical value of the modulus of elasticity.

Fig. 3 shows that the bending, to which the integrated-circuit device 300 is subjected, is completely accommodated by the elastically deformable bridges 310 to 318. The substrate islands 302 to 308 form rigid sections of the device. The extension of the substrate islands 303 to 308 should be chosen much smaller than the radius of curvature, to which the electronic-circuit device 300 is subjected under operating conditions. This way, all stress will be relieved by the elastically deformable bridges.

As will be shown with reference to the following figures in more detail, the flexible bridges typically contain electrical interconnects between the substrate islands. The bridges will typically be shorter than the extension of the substrate islands. However, this is not to be construed as a limitation. Depending on a desired application, the bridges can also be longer than the extension of the substrate islands. An example will be will be shown below.

Note that typically certain substrate islands will accommodate certain functions. For instance one or more substrate islands may be dedicated to providing memory capacity. Another substrate island may contain a phase-locked loop (PLL) circuit. Another substrate island may contain a processor circuit. Another example of a dedicated functionality of a substrate island is an analog-digital (A/D) converter circuit. Of course, depending on the substrate island size, several functional circuit modules can be provided on one substrate island. A typical size of the substrate islands is in the millimeter range. However, the size should be chosen according to the flexibility requirements of a particular application.

It is also possible to let several substrate islands perform a single function cooperatively, together also with the bridges, the contribution of which is to provide electrical interconnection between the substrate islands. For instance, several substrate islands together may form an inductor. Another example is a formation of an antenna by a group of substrate islands, for instance arranged in a 10x10-matrix. The antenna can be arranged along outer substrate islands of this matrix. The matrix itself can form a region of a larger integrated-circuit device. The bandwidth of a resonance circuit is typically large enough to accommodate small deviations of the antenna resonance frequency, which can be caused by a deformation of the substrate-island matrix containing the antenna.

In the following, further embodiments and their fabrication will be described in detail.

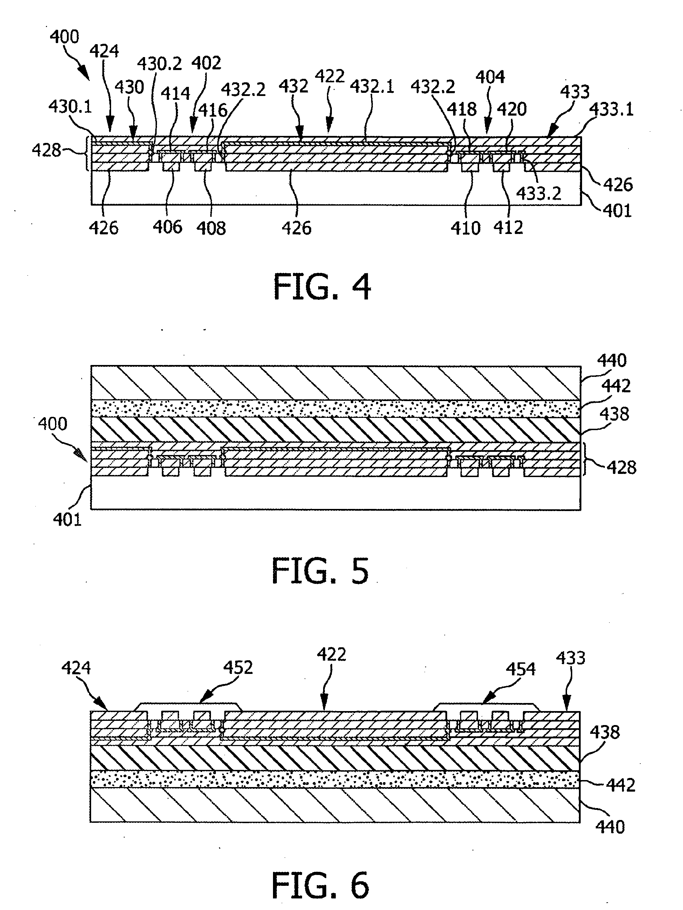

Figs. 4 to 8 show different stages during the production of an embodiment of an integrated circuit device of the invention. The cross sections shown in Figs. 4 to 8 are schematic.

Fig. 4 shows a fully processed wafer 400. The wafer 400 is a wafer provided with electronic circuits in a, for example, a CMOS process. The present example makes use of a standard bulk-silicon IC process, thus using a bulk silicon substrate wafer 401. However, this shall not be construed as a limitation. The process shown in Figs. 4 to 8 can also be used with a SOI-wafer. In the following description, it will be explicitly noted were deviations from the described processing are necessary for an SOI-based fabrication method.

The wafer contains substrate-island regions 402 and 404, which during later processing are to be transformed into individual substrate islands. The substrate-island regions contain active circuit elements 406, 408, 410, and 412. It is understood that the active circuit elements 406 to 412 are representative of any suitable integrated circuits, which can be designed according to the needs of a particular application.

Local interconnect structures 414 to 420on the individual substrate-island regions 402 and 404 provide electrical signal transport within the integrated circuit of the respective substrate island.

The processed wafer 400 further contains bridge regions 422 and 424. The bridge regions contain a layer sequence, which is formed of a field-oxide layer 426 and a typical interconnect stack 428 containing dielectric layers (shown with the same hatching as the field-oxide layer 426) and metal interconnects 430 and 432. The metal interconnects provide signal transport between neighboring substrate islands. The metal interconnects 430 and 432 contain horizontal interconnect sections 430.1 and 432.1, respectively, as well as vertical interconnect sections 430.2 and 432.2. The horizontal sections 430.1 and 432.1 are fabricated in the top metal layer of the interconnect stack 428 in the bridge regions 422 and 424. Furthermore, it is preferred that the metal of the horizontal sections 430.1, 432.1 is designed in a spring shaped zig-zag fashion (not shown in the figures) in a direction perpendicular to the sectional plane shown, that is, parallel to the wafer surface.

It is understood that the wafer 400 continues to the left side beyond what is shown in Figs. 4 to 8 in an identical manner. The right side of wafer 400 in Fig. 4 forms the wafer edge and therefore does not contain a bridge region.

As can be seen, the structure of the bridge regions 430, 432 is identical. This way it can be ensured that also after later processing the bridges to be formed are configured to have an identical or nearly identical value of the modulus of elasticity. In case a bridge is not functional as an electrical interconnect, one or more vertical interconnect sections can be omitted. This way, only a minor modification of the structure is introduced, which forms a negligible contribution to the modulus of elasticity.

Fig. 5 shows the wafer 400 at a later processing stage. At this point, an elastic polymer layer 438 has been applied to the surface of the interconnect stack 428 of wafer 400. On top of the elastic polymer layer, which will, without limitation, in the following also be referred to as a polyimide layer 438, a glass support 440 is attached to the substrate by means of an adhesive layer 442.

At a later processing stage shown in Fig. 6, the silicon substrate wafer 401 has been thinned to a thickness of approximately 10 µm, and etched to form substrate islands 452 and 554. The substrate islands are connected by the bridge regions 422 and 424.

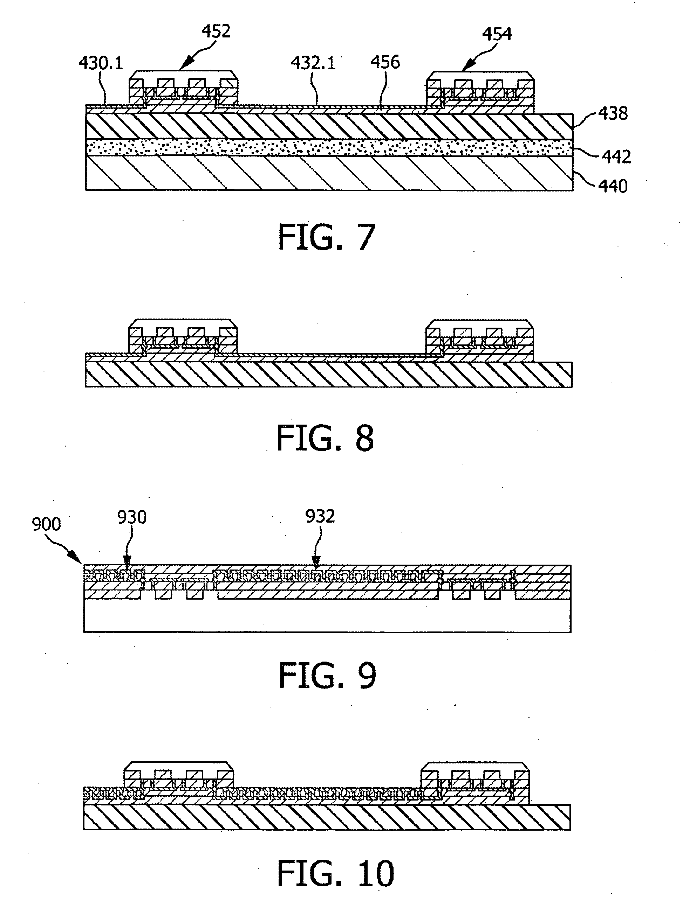

Next, as shown in Fig. 7, the bridge regions are subjected to a blanket anisotropical dry-etch procedure, which removes exposed field-oxide layers 426 and dielectric layers of the layer stack 428. The etching stops on the metal of the interconnects 430.1 and 432.1. Thus, the interconnects are acting as a hard etch mask. Underneath the interconnects, a thin dielectric layer 456 remains after the dry etching step, which ties the interconnect to the polyimide layer 438.

In an alternative embodiment the remaining dielectric layer 456 is removed by continuing with an isotropic etch step, which can for instance be a wet-etch step. This way, the horizontal interconnect sections 430.1 and 432.1 become completely suspended in air. However, typically both sides of the circuit will subsequently be covered with polyimide (not shown), which will embed the interconnects.

Due to the zig-zag shape of the horizontal interconnect sections 430.1 and 432.1, and due to the underlying polyimide layer 438, the bridges will act as springs with identical modulus of elasticity during application of mechanical stress. This, in combination with the fact that only very little dielectric (typically ceramic) material is left, will prevent that the bridges 432 and 434 crack during application of mechanical stress.

In a final step, the result of which is shown in Fig. 8, the glass support 440 and the adhesive layer 442 are removed.

Figs. 9 and 10 show two stages in the fabrication process of an integrated-circuit device of the invention according to another embodiment. The processing for the present embodiment generally resembles that shown in Figs. 4 to 8.

Fig. 9 represents a processing stage that corresponds to that of Fig. 4. A wafer 900 shown in Fig. 9 differs from wafer 400 of Fig. 4 in that metal interconnect structures 930 and 932 have a zig-zag shape also in a direction perpendicular to the wafer surface. This is achieved by letting horizontal sections of the metal interconnects alternate between neighboring interconnect layers, therefore achieving a minimal possible pitch.

Fig. 10 shows the processed wafer after the processing that corresponds to the embodiment of Figs. 4 to 8. The final processing stage shown in Fig. 10 corresponds to that of Fig. 8.

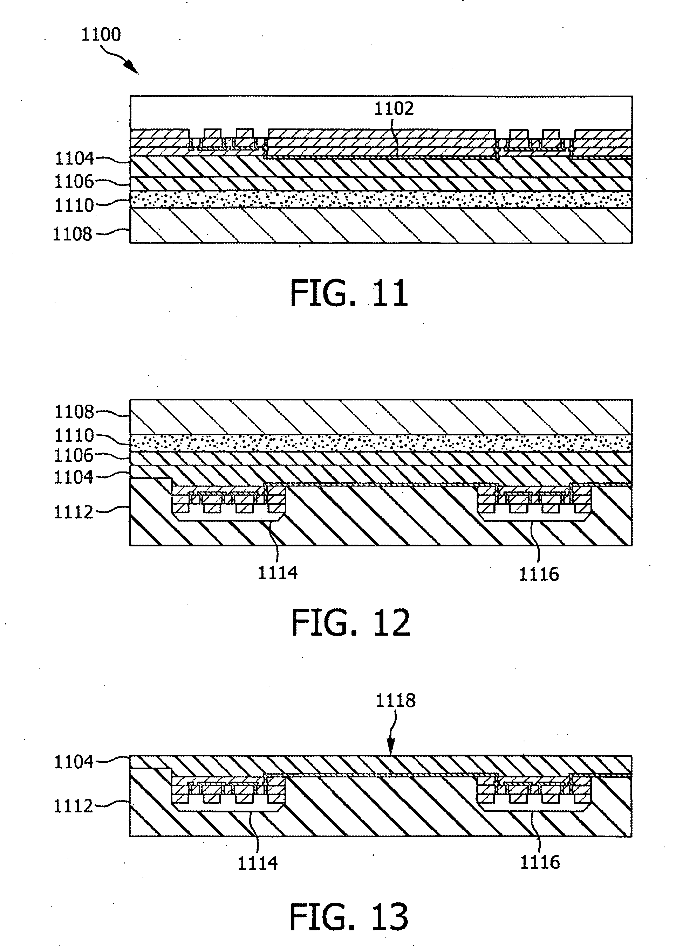

Figs. 11 to 13 show different stages during the production of another embodiment of an integrated circuit device of the invention. A wafer 1100 is processed in a similar manner as described for the embodiment of Figs. 4 to 8. However, minor differences compared to that earlier described processing will be addressed in the following. In the present embodiment, on the basis of a wafer structure 1100 corresponding to that of wafer 400 shown in Fig. 4, the upper metal level 1102 is not covered by a standard interlevel dielectric material, but by an elastic polymer layer 1104. An intermediate lift-off layer 1106 is deposited on the elastic layer 1104, before a support 1108 is attached to the wafer by means of an adhesive layer 1110. The lift-off layer may for instance be a silicon dioxide layer, but another material suitable for a lift-off process can be chosen as well.

Subsequently, the silicon substrate is processed as described earlier with reference to Fig. 7. After that, an elastic polymer layer 1112 is applied so as to embed the circuit islands, shown in the present figure by reference numerals 1114 and 1116, cf. Fig. 12. After that, the glass support 1108 is removed by a lift-off process that selectively removes the silicon dioxide layer 1106, and the adhesive 1110 and support 1108 with it, leaving the finished integrated-circuit device completely embedded into elastic material.

The uniform application of an elastic polymer layer across the whole device ensures that the elastic modulus of the bridges 1118 between these substrate islands 1114 and 1116 can be made identical.

While a preferred material for the elastic polymer layers 1104 and 1112 is polyimide, there are alternative material choices to the polyimide resin, such as a polyamideimide, a polyether-imide, a polysiloxane-imide, a polyether-ketone resin, and similar materials known in the art. It is important that the elastic properties of the chosen material are isotropic to ensure an identical modulus of elasticity of the bridges in all directions of a two-dimensional, matrix-like device.

In the following claims, reference numeral shall not be construed as limiting the scope of the claims.

## Claims

1. An integrated-circuit device comprising a multitude of separate rigid substrate islands (202 to 208; 302 to 308, 452, 454) with circuit elements, a respective substrate island being connected to respective neighbor substrate islands by respective elastically deformable connections (210 to 222; 310 to 318; 438), which contain at least one respective signaling layer (210 to 222; 310 to 318; 432.1) that is made of an electrically conductive material,
**characterized, in that**
- at least one elastically deformable connection between substrate islands has a signaling layer, which is not electrically connected and thus forms a dummy signaling layer (210a to 210c), and wherein
- the elastically deformable connections, which connect a respective substrate island to respective neighbor substrate islands along a first direction, have an elastic deformability in the first direction governed by respective moduli of elasticity, the ratio of which is between 0.5 and 2.0.

2. The integrated-circuit device of claim 1, wherein the ratio of the moduli of elasticity is between 0.67 and 1.5.

3. The integrated-circuit device of claim 1, wherein the ratio of the moduli of elasticity is between 0.8 and 1.25.

4. The integrated-circuit device of claim 1, wherein the elastically deformable connections are inelastically deformable when subjected to a stress that exceeds a threshold stress amount.

5. The integrated-circuit device of claim 1, wherein the elastically deformable connections, which connect a respective substrate island to respective different neighbor substrate islands along at least one second direction, which is different from the first direction, have an elastic deformability in the second direction governed by respective moduli of elasticity, the ratio of which is between 0.5 and 2.0.

6. The integrated-circuit device of claim 1, wherein the elastically deformable connections comprise equal numbers of signaling layers, and wherein the individual signaling layers form either interconnect elements, which electrically connect circuit elements of neighboring substrate islands, or dummy signaling layers.

7. The integrated-circuit device of claim 1, wherein the signaling layers comprised by different elastically deformable connections have equal geometrical extensions.

8. The integrated-circuit device of claim 7, wherein the signaling layers comprised by different connections are made from the same material.

9. The integrated-circuit device of claim 1, wherein the substrate islands, except for substrate islands located in edge positions, are connected to an equal number of neighboring substrate islands.

10. The integrated-circuit device of claim 1, wherein the substrate islands have the shape of a square (202 to 208), of a circle, or of a hexagon.

11. The integrated-circuit device of claim 1 or 5, wherein the elastically deformable connections of a respective substrate island to its neighbor substrate islands along the first or second direction, or along the first and second directions, comprise an equal number of elastically deformable bridges (210a to 210d, 222a to 222d).

12. The integrated-circuit device of claim 11, wherein the elastically deformable bridges are embedded in an elastically deformable material (1104, 1112).

13. The integrated-circuit device of claim 12, wherein the elastically deformable material has a first coefficient of thermal expansion, which is close enough to a second coefficient of thermal expansion of the elastically deformable bridges, so as to prevent a disintegration of the bridges and the elastically deformable material upon a change of temperature during manufacture or operation of the device.

14. The integrated-circuit device of claim 9, wherein, in a stress-free state, the elastically deformable bridges take the form of a spiral, which is configured to partially or completely unwind upon an application of a tensile stress between respective neighboring substrate islands connected by the bridge.

15. The integrated-circuit device of claim 14, wherein the spiral has two spiral arms, which are connected to a substrate island with their respective inner end, and wherein their respective outer end is connected to an outer end of a spiral arm that is associated with a neighboring substrate island.

16. The integrated-circuit device of claim 1, wherein, in a stress-free state, the elastically deformable bridges take the form of one or more folded beams (932), which are configured to partially or completely unfold upon an application of a tensile stress between respective neighboring substrate islands connected by the bridge.

17. The integrated-circuit device of claim 16, wherein the beams (932), without application of tensile stress, are folded in a spring-shaped zig-zag fashion.

18. The integrated-circuit device of claim 16, wherein the substrate islands and the beams (932) are supported by an elastically deformable polymer material.

19. The integrated-circuit device of claim 1, wherein the substrate islands contain at least one electronic circuit from the group of a detector circuit, a memory circuit, a processor circuit, a phase-locked loop circuit, a converter circuit between analog and digital signals, and a sensor circuit.

20. A method for fabricating a integrated-circuit device that has a multitude of separate rigid substrate islands (202 to 208; 302 to 308, 452, 454) with circuit elements, the substrate islands being connected to respective neighbor substrate islands by elastically deformable bridges, the method comprising the steps of
- fabricating a wafer having, at a distance to each other, a multitude of rigid substrate island regions, which contain circuit elements;
- fabricating elastically deformable connections (210 to 222; 310 to 318; 432.1) between neighboring substrate island regions on the wafer and configuring the connections to provide a mechanical connection bridging the distance between the neighboring substrate island regions;
- processing the wafer to transform the substrate island regions of the wafer into substrate islands;
wherein fabricating elastically deformable connections comprises
- fabricating at least one elastically deformable connection between substrate islands that has a signaling layer, which is not electrically connected and thus forms a dummy signaling layer (210a to 210c), and
- configuring the elastically deformable connections, which connect a respective substrate island to respective different neighbor substrate islands along a first direction, to have an elastic deformability in the first direction governed by respective moduli of elasticity, the ratio of which is between 0.5 and 2.0.

21. The method of claim 20, wherein
- the step of fabricating a wafer comprises fabricating the circuit elements and the bridges on a first wafer side; and
- the step of processing the wafer comprises:
- depositing an elastic insulating material on the first wafer side;
- attaching the wafer to a support, with the first wafer side facing the support;
- removing wafer material between substrate island regions to form individual substrate islands; and
- removing the support.

22. The method of claim 20, wherein the step of fabricating elastically deformable connections (210a to 210d, 222a to 222d) between neighboring substrate island regions on the wafer comprises fabricating stretchable electrical interconnects between the substrate islands, either before or after the step of processing the wafer.

23. The method of claim 20, wherein the step of fabricating bridges comprises a step of embedding the electrical interconnects into elastic insulating material.

## Patentansprüche

1. Integrierte Schaltungsvorrichtung mit einer Vielzahl von separaten starren Substratinseln (202 bis 208: 302 bis 308, 452, 454) mit Schaltungselementen, wobei eine jeweilige Substratinsel mit jeweiligen Nachbarsubstratinseln durch jeweilige elastisch verformbare Verbindungen (210 bis 222; 310 bis 318, 438) verbunden ist, die mindestens eine jeweilige Signalisierungsschicht (210 bis 222; 310 bis 318; 432.1) enthalten, welche aus einem elektrisch leitenden Material besteht, **dadurch gekennzeichnet, dass**
- mindestens eine elastisch verformbare Verbindung zwischen Substratinseln eine Signalisierungsschicht hat, die nicht elektrisch verbunden ist und somit eine Signalisierungsschichtattrappe (201 a bis 210c) bildet, und wobei
- die elastisch verformbaren Verbindungen, die eine jeweilige Substratinsel mit jeweiligen Nachbarsubstratinseln entlang einer ersten Richtung verbinden, eine elastische Verformbarkeit in der ersten Richtung aufweisen, die durch jeweilige Elastizitätsmoduln vorgegeben wird, deren Verhältnis zwischen 0,5 und 2,0 liegt.

2. Integrierte Schaltungsvorrichtung nach Anspruch 1, wobei das Verhältnis der Elastizitätsmoduln zwischen 0,67 und 1,5 liegt.

3. Integrierte Schaltungsvorrichtung nach Anspruch 1, wobei das Verhältnis der Elastizitätsmoduln zwischen 0,8 und 1,25 liegt.

4. Integrierte Schaltungsvorrichtung nach Anspruch 1, wobei die elastisch verformbaren Verbindungen inelastisch verformbar sind, wenn sie einer Beanspruchung unterworfen werden, die ein Schwellenwertbeanspruchungsmaß überschreitet.

5. Integrierte Schaltungsvorrichtung nach Anspruch 1, wobei die elastisch verformbaren Verbindungen, die eine jeweilige Substratinsel mit jeweiligen unterschiedlichen Nachbarsubstratinseln entlang mindestens einer zweiten Richtung verbinden, die sich von der ersten Richtung unterscheidet, eine elastische Verformbarkeit in der zweiten Richtung aufweisen, die durch jeweilige Elastizitätsmoduln vorgegeben wird, deren Verhältnis zwischen 0,5 und 2,0 liegt.

6. Integrierte Schaltungsvorrichtung nach Anspruch 1, wobei die elastisch verformbaren Verbindungen gleiche Anzahlen von Signalisierungsschichten beinhalten, und wobei die einzelnen Signalisierungsschichten entweder Verbindungselemente, die Schaltungselemente der benachbarten Substratinseln elektrisch verbinden, oder Signalisierungsschichtattrappen bilden.

7. Integrierte Schaltungsvorrichtung nach Anspruch 1, wobei die durch unterschiedliche elastisch verformbare Verbindungen beinhalteten Signalisierungsschichten gleiche geometrische Ausmaße haben.

8. Integrierte Schaltungsvorrichtung nach Anspruch 7, wobei die durch unterschiedliche Verbindungen beinhalteten Signalisierungsschichten aus dem gleichen Material bestehen.

9. Integrierte Schaltungsvorrichtung nach Anspruch 1, wobei die Substratinseln, mit Ausnahme von Substratinseln an Randpositionen, mit einer gleichen Anzahl von benachbarten Substratinseln verbunden sind.

10. Integrierte Schaltungsvorrichtung nach Anspruch 1, wobei die Substratinseln die Form eines Quadrats (202 bis 208), eines Kreises oder eines Sechsecks haben.

11. Integrierte Schaltungsvorrichtung nach Anspruch 1 oder 5, wobei die elastisch verformbaren Verbindungen einer jeweiligen Substratinsel zu ihren Nachbarsubstratinseln entlang der ersten oder der zweiten Richtung oder entlang der ersten und der zweiten Richtung eine gleiche Anzahl von elastisch verformbaren Brücken (210a bis 210d, 222a bis 222d) umfassen.

12. Integrierte Schaltungsvorrichtung nach Anspruch 11, wobei die elastisch verformbaren Brücken in ein elastisch verformbares Material (1104, 1112) eingebettet sind.

13. Integrierte Schaltungsvorrichtung nach Anspruch 12, wobei das elastisch verformbare Material einen ersten thermischen Ausdehnungskoeffizienten hat, der nahe genug an einem zweiten thermischen Ausdehnungskoeffizienten der elastisch verformbaren Brücken liegt, um eine Zersetzung der Brücken und des elastisch verformbaren Materials bei einer Änderung der Temperatur während der Herstellung oder des Betriebs der Vorrichtung zu verhindern.

14. Integrierte Schaltungsvorrichtung nach Anspruch 9, wobei die elastisch verformbaren Brücken in einem beanspruchungsfreien Zustand die Form einer Spirale annehmen, die konfiguriert ist, um sich bei Ausüben einer Zugspannung zwischen jeweiligen benachbarten Substratinseln, die durch die Brücke verbunden sind, teilweise oder vollständig abzuwickeln.

15. Integrierte Schaltungsvorrichtung nach Anspruch 14, wobei die Spirale zwei Spiralarme hat, die mit ihrem jeweiligen inneren Ende mit einer Substratinsel verbunden sind, und wobei ihr jeweiliges äußeres Ende mit einem äußeren Ende eines Spiralarms verbunden ist, der zu einer benachbarten Substratinsel gehört.

16. Integrierte Schaltungsvorrichtung nach Anspruch 1, wobei die elastisch verformbaren Brücken in einem belastungsfreien Zustand die Form von einem oder mehreren gefalteten Trägern (932) annehmen, die konfiguriert sind, um sich bei Ausübung einer Zugspannung zwischen jeweiligen benachbarten Substratinseln, die durch die Brücke verbunden sind, teilweise oder vollständig zu entfalten.

17. Integrierte Schaltungsvorrichtung nach Anspruch 16, wobei die Träger (932) ohne Ausübung einer Zugspannung in eine federförmigen Zickzackweise gefaltet sind.

18. Integrierte Schaltungsvorrichtung nach Anspruch 16, wobei die Substratinseln und die Träger (932) durch ein elastisch verformbares Polymermaterial unterstützt werden.

19. Integrierte Schaltungsvorrichtung nach Anspruch 1, wobei die Substratinseln mindestens eine elektronische Vorrichtung aus der Gruppe bestehend aus einer Detektorschaltung, einer Speicherschaltung, einer Prozessorschaltung, einer Phasenverriegelungsschaltung, einer Umsetzerschaltung zwischen analogen und digitalen Signalen und einer Sensorschaltung enthalten.

20. Verfahren zum Herstellen einer integrierten Schaltungsvorrichtung mit einer Vielzahl von separaten starren Substratinseln (202 bis 208; 302 bis 308, 452, 454) mit Schaltungselementen, wobei die Substratinseln durch elastisch verformbare Brücken mit jeweiligen Nachbarsubstratinseln verbunden sind, wobei das Verfahren die folgenden Schritte umfasst:
- Herstellen eines Wafers mit einer Vielzahl von starren Substratinselregionen in einem Abstand zueinander, die Schaltungselemente enthalten;
- Herstellen elastisch verformbarer Verbindungen (210 bis 222; 310 bis 318; 432.1) zwischen benachbarten Substratinselregionen auf dem Wafer und Konfigurieren der Verbindungen, um eine mechanische Verbindung zu schaffen, die den Abstand zwischen den benachbarten Substratinselregionen überbrückt;
- Bearbeiten des Wafers, um die Substratinselregionen des Wafers in Substratinseln zu verwandeln;
wobei das Herstellen elastisch verformbarer Verbindungen Folgendes umfasst:
- Herstellen mindestens einer elastisch verformbaren Verbindung zwischen Substratinseln, die eine Signalisierungsschicht hat, welche nicht elektrisch verbunden ist und somit eine Signalisierungsschichtattrappe (210a bis 210c) bildet, und
- Konfigurieren der elastisch verformbaren Verbindungen, die eine jeweilige Substratinsel mit jeweiligen Nachbarsubstratinseln entlang einer ersten Richtung verbinden, dergestalt, dass sie eine elastische Verformbarkeit in der ersten Richtung aufweisen, die durch jeweilige Elastizitätsmoduln vorgegeben wird, deren Verhältnis zwischen 0,5 und 2,0 liegt.

21. Verfahren nach Anspruch 20, wobei
- der Schritt des Herstellens eines Wafers das Herstellen der Schaltungselemente und der Brücken auf einer ersten Waferseite umfasst, und
- der Schritt des Bearbeitens des Wafers Folgendes umfasst:
- Ablagern eines elastischen isolierenden Materials auf der ersten Waferseite;
- Anbringen des Wafers an einer Halterung, wobei die erste Waferseite der Halterung gegenüberliegt;
- Entfernen des Wafermaterials zwischen Substratinselregionen, um einzelne Substratinseln zu bilden; und
- Entfernen der Halterung.

22. Verfahren nach Anspruch 20, wobei der Schritt des Herstellens elastisch verformbarer Verbindungen (210a bis 210d, 222a bis 222d) zwischen benachbarten Substratinselregionen auf dem Wafer das Herstellen dehnbarer elektrischer Verbindungen zwischen den Substratinseln entweder vor oder nach dem Schritt des Bearbeitens des Wafers umfasst.

23. Verfahren nach Anspruch 20, wobei der Schritt des Herstellens von Brücken einen Schritt des Einbettens der elektrischen Verbindungen in elastisches isolierendes Material umfasst.

## Revendications

1. Dispositif à circuit intégré comprenant une multitude d'îlots de substrat rigide indépendants (202 à 208 ; 302 à 308, 452, 454) avec des éléments de circuit, un îlot de substrat respectif étant connecté aux îlots de substrat voisins respectifs par des connexions élastiquement déformables respectives (210 à 222 ; 310 à 318 ; 438), qui contiennent au moins une couche de signalisation respective (210 à 222 ; 310 à 318 ; 432.1) qui est constituée d'un matériau électriquement conducteur, **caractérisé en ce que**
- au moins une connexion élastiquement déformable entre les îlots de substrat a une couche de signalisation, qui n'est pas reliée électriquement et forme ainsi une couche de signalisation factice (210a à 210c), et dans lequel
- les connexions élastiquement déformables, qui relient un îlot de substrat respectif aux îlots de substrat voisins respectifs le long d'une première direction, ont une capacité de déformation élastique dans la première direction régie par les modules d'élasticité respectifs, dont le rapport est compris entre 0,5 et 2,0.

2. Dispositif à circuit intégré selon la revendication 1, dans lequel le rapport des modules d'élasticité est compris entre 0,67 et 1,5.

3. Dispositif à circuit intégré selon la revendication 1, dans lequel le rapport des modules d'élasticité est compris entre 0,8 et 1,25.

4. Dispositif à circuit intégré selon la revendication 1, dans lequel les connexions élastiquement déformables sont déformables de façon non élastique lorsqu'elles sont soumises à une contrainte qui dépasse une valeur de contrainte seuil.

5. Dispositif à circuit intégré selon la revendication 1, dans lequel les connexions élastiquement déformables, qui connectent un îlot de substrat respectif à des îlots de substrat voisins différents respectifs le long d'au moins une deuxième direction, qui est différente de la première direction, ont une capacité de déformation élastique dans la deuxième direction régie par les modules d'élasticité respectifs, dont le rapport est compris entre 0,5 et 2,0.

6. Dispositif à circuit intégré selon la revendication 1, dans lequel les connexions élastiquement déformables comprennent des nombres égaux de couches de signalisation, et dans lequel les couches de signalisation individuelles forment ou des éléments d'interconnexion, qui connectent électriquement des éléments de circuit d'îlots de substrat voisins, ou des couches de signalisation factices.

7. Dispositif à circuit intégré selon la revendication 1, dans lequel les couches de signalisation comprises par différentes connexions élastiquement déformables ont des extensions géométriques égales.

8. Dispositif à circuit intégré selon la revendication 7, dans lequel les couches de signalisation comprises par différentes connexions sont constituées du même matériau.

9. Dispositif à circuit intégré selon la revendication 1, dans lequel les îlots de substrat, à l'exception des îlots de substrat situés à des positions de bord, sont connectés à un nombre égal d'îlots de substrat voisins.

10. Dispositif à circuit intégré selon la revendication 1, dans lequel les îlots de substrat ont la forme d'un carré (202 à 208), d'un cercle, ou d'un hexagone.

11. Dispositif à circuit intégré selon la revendication 1 ou 5, dans lequel les connexions élastiquement déformables d'un îlot de substrat respectif aux îlots de substrat voisins le long de la première ou la deuxième direction, ou le long des première et deuxième directions, comprennent un nombre égal de ponts élastiquement déformables (210a à 210d, 222a à 222d).

12. Dispositif à circuit intégré selon la revendication 11, dans lequel les ponts élastiquement déformables sont imbriqués dans un matériau élastiquement déformable (1104, 1112).

13. Dispositif à circuit intégré selon la revendication 12, dans lequel le matériau élastiquement déformable a un premier coefficient de dilatation thermique, qui est suffisamment proche d'un deuxième coefficient de dilatation thermique des ponts élastiquement déformables, de façon à empêcher une désintégration des ponts et du matériau élastiquement déformable lors d'un changement de température durant la fabrication ou l'utilisation du dispositif.

14. Dispositif à circuit intégré selon la revendication 9, dans lequel, dans un état dépourvu de contrainte, les ponts élastiquement déformables prennent la forme d'une spirale, qui est conçue pour se dérouler partiellement ou complètement lors de l'application d'une contrainte de traction entre des îlots de substrat voisins respectifs connectés par le pont.

15. Dispositif à circuit intégré selon la revendication 14, dans lequel la spirale comporte deux bras de spirale, qui sont connectés à un îlot de substrat avec leur extrémité interne respective, et dans lequel leur extrémité externe respective est connectée à une extrémité externe d'un bras de spirale qui est associé à un îlot de substrat voisin.

16. Dispositif à circuit intégré selon la revendication 1, dans lequel, dans un état dépourvu de contrainte, les ponts élastiquement déformables prennent la forme d'une ou plusieurs poutres pliées (932), qui sont conçues pour se déplier partiellement ou complètement lors de l'application d'une contrainte de traction entre des îlots de substrat voisins respectifs connectés par le pont.

17. Dispositif à circuit intégré selon la revendication 16, dans lequel les poutres (932), sans application de contrainte de traction, sont pliées en zigzag en forme de ressort.

18. Dispositif à circuit intégré selon la revendication 16, dans lequel les îlots de substrat et les poutres (932) sont supportés par un matériau polymère élastiquement déformable.

19. Dispositif à circuit intégré selon la revendication 1, dans lequel les îlots de substrat contiennent au moins un circuit électronique provenant du groupe d'un circuit détecteur, un circuit de mémoire, un circuit processeur, un circuit de boucle à verrouillage de phase, un circuit convertisseur entre des signaux analogiques et numériques, et un circuit capteur.

20. Procédé pour la fabrication d'un dispositif à circuit intégré qui a une multitude d'îlots de substrat rigide indépendants (202 à 208 ; 302 à 308, 452, 454) avec des éléments de circuit, les îlots de substrat étant connectés aux îlots de substrat voisins respectifs par des ponts élastiquement déformables, le procédé comprenant les étapes consistant à
- fabriquer une tranche ayant, à une distance les unes des autres, une multitude de régions d'îlot de substrat rigides, qui contiennent des éléments de circuit ;
- fabriquer des connexions élastiquement déformables (210 à 222 ; 310 à 318 ; 432.1) entre des régions d'îlot de substrat voisines sur la tranche et configurer les connexions pour fournir une liaison mécanique reliant par un pont la distance entre les régions d'îlot de substrat voisines ;
- traiter la tranche pour transformer les régions d'îlot de substrat de la tranche en îlots de substrat ;
dans lequel la fabrication des connexions élastiquement déformables comprend
- la fabrication d'au moins une connexion élastiquement déformable entre les îlots de substrat qui a une couche de signalisation, qui n'est pas reliée électriquement et forme ainsi une couche de signalisation factice (210a à 210c), et
- la configuration des connexions élastiquement déformables, qui relient un îlot de substrat respectif aux îlots de substrat voisins différents respectifs le long d'une première direction, pour avoir une capacité de déformation élastique dans la première direction régie par les modules d'élasticité respectifs, dont le rapport est compris entre 0,5 et 2,0.

21. Procédé selon la revendication 20, dans lequel
- l'étape consistant à fabriquer une tranche comprend la fabrication des éléments de circuit et des ponts sur un premier côté de tranche ; et
- l'étape consistant à traiter la tranche comprend :
- le dépôt d'un matériau isolant élastique sur le premier côté de la tranche ;
- la fixation de la tranche à un support, avec le premier côté de la tranche faisant face au support ;
- le retrait du matériau de tranche entre les régions d'îlot de substrat de façon à former les îlots de substrat individuels ; et
- le retrait du support.

22. Procédé selon la revendication 20, dans lequel l'étape consistant à fabriquer des connexions élastiquement déformables (210a à 210d, 222a à 222d) entre les régions d'îlot de substrat voisines sur la tranche comprend la fabrication d'interconnexions électriques étirables entre les îlots de substrat, ou avant ou après l'étape de traitement de la tranche.

23. Procédé selon la revendication 20, dans lequel l'étape de fabrication des ponts comprend une étape consistant à imbriquer les interconnexions électriques dans le matériau isolant élastique.
